# EUROPÄISCHE PATENTANMELDUNG

(11) **EP 2 543 685 A1**
(43) Veröffentlichungstag der Anmeldung: **09.01.2013**
(21) Anmeldenummer: 11175125.1
(22) Anmeldetag: 22.07.2011
(51) Int. Cl.: C08F 12/08, C08G 79/00, C07F 1/08, C08J 3/24, H01L 51/00, C09K 11/66, H05B 33/14

(54) **Verfahren zur kovalenten Bindung eines Metallkomplexes an ein Polymer**

(30) Priorität: 08.07.2011 EP 11173374
(71) Anmelder: cynora GmbH, 76344 Eggenstein-Leopoldshafen (DE)
(72) Erfinder: Baumann, Thomas, 76131 Karlsruhe (DE); Grab, Tobias, 76133 Karlsruhe (DE); Bächle, Michael, 76133 Karlsruhe (DE); Volz, Daniel, 76131 Karlsruhe (DE)
(74) Vertreter: Hoppe, Georg Johannes

(57) **Zusammenfassung**

Die Erfindung betrifft ein Verfahren zur kovalenten Bindung eines organischen Metallkomplexes an eine polymere Matrix. Das Verfahren umfasst die Durchführung einer ersten Reaktion, die einen ersten Reaktanden in Form eines organischen Metallkomplexes und einen zweiten Reaktanden in Form eines Polymers aufweist, wobei während der Reaktion der Metallkomplex an das Polymer kovalent gebunden wird. Erfindungsgemäß wird die Reaktion durch den Metallkomplex katalysiert.

## Beschreibung

Die Erfindung betrifft insbesondere ein Verfahren zur kovalenten Bindung eines organischen Metallkomplexes an ein Polymer (eine polymere Matrix). Der organische Metallkomplex weist mindestens ein Metallzentrum und mindestens einen organischen Liganden auf. Das Verfahren umfasst die Durchführung einer ersten Reaktion, die einen ersten Reaktanden in Form eines organischen Metallkomplexes und einen zweiten Reaktanden in Form eines Polymers aufweist, wobei während der Reaktion der Metallkomplex kovalent an das Polymer gebunden wird.

### Einleitung

Phosphoreszierende Übergangsmetallkomplexe gewinnen aufgrund ihrer Eigenschaften als hocheffiziente Emitter in optoelektronischen Bauteilen wie OLEDs zunehmend stärker an Bedeutung. Die vom Übergangsmetallatom (Schwermetallatom) induzierte Spin-Bahn-Kopplung resultiert in einer erhöhten Intersystem-Crossing-Rate vom angeregten Singulett- zum Triplett-Zustand und somit zu einer Nutzung sowohl der Singulett- als auch der Triplett-Exzitonen für die Emission und ermöglicht dadurch eine theoretisch erreichbare innere Quantenausbeute von 100 %.

Diese phosphoreszierenden Farbstoffe werden üblicherweise in entsprechende energetisch angepasste Hostmaterialien eingebracht. Aufgrund der leichteren Verarbeitbarkeit durch flüssige Prozessierung aus der Lösung eignen sich hierfür insbesondere polymere Strukturen. Diese sollten im Idealfall weitere Aufgaben wie eine räumliche Trennung der Farbstoffmoleküle zur Vermeidung unerwünschter Konzentrations-Quenchprozesse und Triplett-Triplett-Annihilierung unter Emissionsminderung, verbesserte Ladungsträgerinjektion und -transport und eine erhöhte Rekombinationswahrscheinlicheit direkt auf den Emittermolekülen übernehmen.

Demnach stellt die Kombination geeigneter polymerer Hoststrukturen mit entsprechenden statistisch eingemischten Emitterverbindungen und zusätzlich eingebrachten Ladungstransportmolekülen eine vielfältig angewandete Methode zur Herstellung polymerer lichtemittierender Dioden (PLEDs) dar. Obwohl die auf diese Art dargestellten OLED-Bauteile meist hohe Effizienzen aufweisen, können diese Mischsysteme jedoch unerwünschten Phasenseparierungen, Aggregierungen oder Kristallisationsprozessen unterliegen, die sich nachteilig auf die Leistungsfähigkeit und Lebensdauer der Bauteile auswirken. Somit ist die Herstellung angepasster (Co)polymere, die unterschiedliche Funktionen wie Ladungstransport und Emission übernehmen, bei gleichzeitiger Nutzung der Vorteile der flüssigen Verarbeitung von stetig zunehmendem Interesse.

Zur Synthese phosphoreszierender Polymere mit kovalent angebundenen Übergangsmetallkomplexen ist im Stand der Technik die nachträgliche Anbindung der Metallkomplexe an die vorher dargestellten, mit funktionellen Gruppen versehenen Polymere ("Komplexierung am Polymer") bekannt. Es ist wünschenswert, derartige Anbindungsreaktionen zu optimieren.

### Beschreibung

Die Erfindung betrifft in einem ersten Aspekt ein Verfahren zur kovalenten Bindung eines organischen Metallkomplexes an ein Polymer. Der organische Metallkomplex weist mindestens ein Metallzentrum und mindestens einen organischen Liganden auf, wobei die Bindung des Metallkomplexes an die Matrix über den mindestens einen Liganden erfolgt.

Das Verfahren umfasst das Durchführen einer ersten Reaktion, die einen ersten Reaktanden in Form eines organischen Metallkomplexes und einen zweiten Reaktanden in Form eines Polymers aufweist. Während der ersten Reaktion wird der Metallkomplex über mindestens einen Liganden kovalent an das Polymer gebunden. Diese erste Reaktion wird erfindungsgemäß durch den an das Polymer gebundenen Metallkomplex katalysiert.

Das Metallzentrum des Metallkomplexes stellt somit das katalysierende Agens der Reaktion dar. Demgemäß kann das Metallzentrum Re, Fe, Ru, Os, Co, Rh, Ir, Ni, Pd, Pt, Cu, Ag, Au, Zn, Cd, Hg, Sn und/oder Pb sein, und zwar in atomarer oder ionischer Form, also als kationisches Zentralion des Metallkomplexes. Bevorzugter Weise ist das Metallzentrum Cu. Wenn die erste Reaktion als Kreuzkupplungsreaktion wie beispielsweise Suzuki-, Stille- Negishi-, Kumada-, Hiyama-, und Sonogashira-Reaktion durchgeführt wird, ist das Metallzentrum bevorzugt Pd, Pt, oder Ni.

Während dieser ersten Reaktion wird der Metallkomplex an das Polymer gebunden, wobei diese Bindung *einseitig* oder mindestens *zweiseitig* sein kann, d. h. es kann eine Anbindung des Metallkomplexes an nur ein Polymermolekül oder es kann eine gleichzeitige Anbindung des Metallkomplexes an mindestens zwei verschiedene Polymermoleküle erfolgen, so dass es zu einer Querverknüpfung des Metallkomplexes im Polymer kommt, wodurch sich ein mehrdimensionales Netzwerk bildet.

Sofern in einer Ausführungsform des Verfahrens ein mehrdimensionales Netzwerk gebildet wird (Querverknüpfung), kann dies in seiner einfachsten Ausprägung einer leiterähnliche (zweidimensionale) Struktur sein, bei der zwei Polymermoleküle durch mindestens einen Metallkomplex verknüpft sind, der mit je einem der Polymermoleküle mindestens eine kovalente Bindung ausbildet. Weiterhin sind komplizierte dreidimensionale Netzwerke als Produkt der ersten Reaktion möglich, die mittels einer variablen Zahl von Polymermolekülen querverknüpfte Metallkomplexe umfassen. Der querverknüpfte Metallkomplex ist somit im mehrdimensionalen Netzwerk immobilisiert.

Zur kovalenten Verknüpfung des organischen Metallkomplexes an den zweiten Reaktanden stehen unterschiedliche Strategien zur Verfügung. Dabei werden allgemein Paare miteinander korrespondierender chemischer Gruppen verwendet, die miteinander eine kovalente chemische Bindung ausbilden können. Diese chemischen Gruppen, die hier auch als Ankergruppen bezeichnet werden, gehören einer ersten Ankergruppenspezies oder einer zweiten Ankergruppenspezies an, wobei Ankergruppen der ersten Ankergruppenspezies mit Ankergruppen der zweiten Ankergruppenspezies eine kovalente Bindung ausbilden können, nicht aber Ankergruppen einer ersten Ankergruppenspezies untereinander oder Ankergruppen einer zweiten Ankergruppenspezies untereinander.

Nachfolgend wird zunächst die einseitigen Verknüpfung (A), dann die zweiseitige Verknüpfung (Querverknüpfung) (B) erläutert.

A. Bei einer ersten Strategie der einseitigen kovalenten Verknüpfung des organischen Metallkomplexes an den zweiten Reaktanden weist der Metallkomplex eine Ankergruppe einer ersten Ankergruppenspezies auf, die der kovalenten Bindung des Metallkomplexes an das Polymer dient. Der zweite Reaktand weist mindestens eine Ankergruppe einer zweiten Ankergruppenspezies auf, die zur Bindung des zweiten Reaktanden an die Ankergruppe des Metallkomplexes geeignet ist. Die Bindung des Metallkomplexes an das Polymer erfolgt durch Reaktion der Ankergruppen des Metallkomplexes mit einer zweiten Ankergruppe eines zweiten Reaktanden.

Bei einer zweiten Strategie der einseitigen kovalenten Verknüpfung des organischen Metallkomplexes an den zweiten Reaktanden nimmt ein dritter Reaktand an der ersten Reaktion teil, der auch als "Spacer"-Molekül bezeichnet werden kann.

Dabei weist der Metallkomplex eine Ankergruppe einer ersten Ankergruppenspezies auf, die zur kovalenten Einbindung des Metallkomplexes in die Matrix über einer zweiten Ankergruppe geeignet ist. Der zweite Reaktand weist eine Ankergruppe einer ersten Ankergruppenspezies auf, die der Bindung des zweiten Reaktanden an eine zweite Ankergruppe dient, so dass der Metallkomplex nicht unmittelbar an den zweiten Reaktanden binden kann. Zur Ausbildung einer kovalenten Bindung zwischen Metallkomplex und zweitem Reaktanden wird ein dritter Reaktand zugegeben, der zwei Ankergruppen einer zweiten Ankergruppenspezies aufweist, wobei jede dieser Ankergruppen des dritten Reaktanden mit je einer ersten Ankergruppe (nämlich des Metallkomplexes und des zweiten Reaktanden) eine kovalente Bindung eingehen kann. Somit erfolgt die Bindung des Metallkomplexes an das Polymer durch Reaktion der Ankergruppe des Metallkomplexes und durch Reaktion der Ankergruppe des zweiten Reaktanden mit einem dem selben dritten Reaktanden, so dass es zu einer Anbindung des Metallkomplexes an das Polymer kommt.

B. Bei einer ersten Strategie der zweiseitigen kovalenten Verknüpfung des organischen Metallkomplexes an den zweiten Reaktanden weist der Metallkomplex mindestens zwei Ankergruppen einer ersten Ankergruppenspezies auf, die der kovalenten Bindung des Metallkomplexes an das Polymer dienen. Der zweite Reaktand weist mindestens eine Ankergruppe einer zweiten Ankergruppenspezies auf, die zur Bindung des zweiten Reaktanden an eine erste Ankergruppe des Metallkomplexes geeignet ist. Die Bindung des Metallkomplexes an das Polymer erfolgt durch Reaktion der mindestens zwei Ankergruppen des Metallkomplexes mit je einer zweiten Ankergruppe eines zweiten Reaktanden.

Bei einer zweiten Strategie der kovalenten Verknüpfung des organischen Metallkomplexes an den zweiten Reaktanden nimmt ein dritter Reaktand als "Spacer"-Molekül an der ersten Reaktion teil.

Dabei weist der Metallkomplex mindestens zwei Ankergruppen einer ersten Ankergruppenspezies auf, der zur kovalenten Einbindung des Metallkomplexes in die Matrix über einer zweiten Ankergruppe geeignet ist. Der zweite Reaktand weist eine Ankergruppe einer ersten Ankergruppenspezies auf, die der Bindung des zweiten Reaktanden an eine zweite Ankergruppe dient, so dass der Metallkomplex nicht unmittelbar an den zweiten Reaktanden binden kann. Zur Ausbildung einer kovalenten Bindung zwischen Metallkomplex und zweitem Reaktanden wird ein dritter Reaktand zugegeben, der zwei Ankergruppen einer zweiten Ankergruppenspezies aufweist, wobei jede dieser Ankergruppen des dritten Reaktanden mit je einer ersten Ankergruppe (nämlich des Metallkomplexes und des zweiten Reaktanden) eine kovalente Bindung eingehen kann. Somit erfolgt die Bindung des Metallkomplexes in das mehrdimensionale Netzwerk durch Reaktion der Ankergruppe des Metallkomplexes und durch Reaktion der Ankergruppe des zweiten Reaktanden mit demselben dritten Reaktanden, so dass es zu einer Querverknüpfung des Metallkomplexes kommt. Der dritte Reaktand ("Spacer"-Molekül), kann z. B. eine Alkylkette einer gewünschten Kettenlänge sein, das an zwei voneinander beabstandeten Molekülteilen, z. B. einander gegenüberliegenden Enden, je eine Ankergruppe aufweist, der die Anbindung an Metallkomplex bzw. zweiten Reaktanden vermittelt. Neben Alkylketten sind auch Aryl-, Heteroaryl-, Alkenyl-, Alkinyl-, Trialkylsilyl- und Triarylsilyl-Gruppen bzw. substituierte Alkyl-, Aryl-, Heteroaryl- und Alkenyl-Gruppen, optional mit Substituenten wie Halogenen, niedrigen Alkylgruppen und/oder elektronenschiebenden und - ziehenden Gruppen, sowie gängigen Ladungstransporteinheiten wie beispielsweise Arylamine, Carbazole, Benzimidazole, Oxadiazole etc. möglich. Die Substituenten können auch zu anellierten Ringsystemen führen.

Bevorzugter Weise sind der Metallkomplex und der zweite Reaktand in einem (insbesondere zur OLED-Bauteilherstellung) gängigen organischen Lösemittel löslich. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol und Tetrahydrofuran. In einer bevorzugten Ausgestaltung der Erfindung ist das gebildete mehrdimensionale Netzwerk mit querverknüpften organischen Metallkomplexen unlöslich, was insbesondere die Ausbildung einer Struktur mehrerer übereinanderliegender Schichten eines derartigen mehrdimensionalen Netzwerks in einfacher Weise möglich macht.

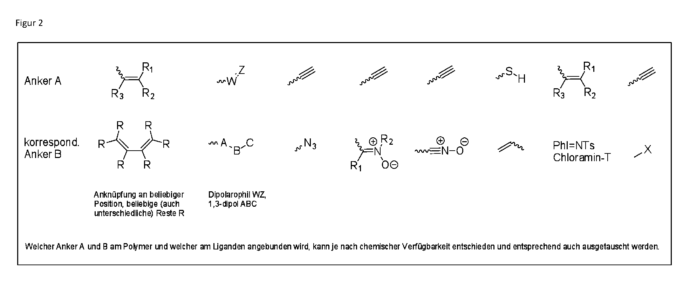

Die erste und zweite Ankergruppe können insbesondere ausgewählt sein aus der in Figur 2 gezeigten Gruppe chemischer Reste. Sofern es sich bei dem Metallkomplex um einen Emitter handelt, steht die Ankergruppe bevorzugter weise nicht in Konjugation zum Emittersystem, um die Emission des Komplexes nicht zu beeinflussen.

Grundsätzlich kann jedweder organischer Übergangsmetallkomplex in dem Verfahren verwendet werden, der an mindestens einem seiner organischen Liganden eine erste Ankergruppe trägt. Insbesondere weist der Metallkomplex neben der ersten Ankergruppe mindestens ein Metallzentrum und mindestens einen Liganden auf. Der Metallkomplex kann ein- oder mehrkernig (zwei-, drei-, vierkernig, etc.) sein und kann einen oder mehrere Liganden tragen. Die Liganden können ein- oder mehrzähnig sein. Sofern ein einkerniger Komplex nur einen Liganden trägt, ist dieser Ligand mehrzähnig. Wenn der Komplex nicht neutral ist, ist ein entsprechendes Gegenion bereitzustellen, das aber bevorzugt nicht an der ersten Reaktion wie hier beschrieben teilnimmt.

Bevorzugte organische Metallkomplexe sind beispielsweise Lichtemitter, die in optoelektronischen Bauteilen, wie OLEDs eingesetzt werden können. Eine weitere Gruppe bevorzugte Metallkomplexe sind Halbleiter. Derartige emittierende und halbleitende Metallkomplexe sind im Stand der Technik bekannt.

Die Anzahl der Ankergruppen an einem Metallkomplex ist abhängig davon, ob der Metallkomplex einseitig oder mindestens zweiseitig kovalent an ein Polymer gebunden werden soll.

Für eine einseitige Bindung eines Metallkomplexes an ein Polymer weist der Metallkomplex eine Ankergruppe auf.

Mindestens ein Ligand des Metallkomplexes weist eine erste Ankergruppe auf. Insgesamt weist ein Metallkomplex für eine mindestens zweiseitige Bindung mindestens zwei Ankergruppen bevorzugt einer Ankergruppenspezies auf, die an einem oder bevorzugt auf zwei Liganden des Metallkomplexes verteilt angeordnet sein können. Es ist somit auch möglich, dass mehrere Liganden eines Metallkomplexes eine oder mehrere Ankergruppen aufweisen, wobei die Anzahl der Ankergruppen an dem Metallkomplex und an dem zweiten Liganden den Querverknüpfungsgrad bestimmt.

Das in einer bevorzugten Ausgestaltung des Verfahrens bei Bindung eines Metallkomplexes an mehr als ein Polymer (mindestens zweiseitige Bindung) gebildete mehrdimensionale Netzwerk ist ein zweidimensionales oder dreidimensionales Netzwerk. Bevorzugt ist ein dreidimensionales Netzwerk.

Der in dem Verfahren verwendete zweite Reaktand ist ein Polymer. Polymere sind Moleküle, die aus mindestens 10, bevorzugt mindestens 15, stärker bevorzugt aus mindestens 20 und am meisten bevorzugt aus mindestens 30 strukturell gleichen oder ähnlichen Einheiten aufgebaut sind. Beispiele für Polymere sind Polystyrol, Polyethylen, Polypropylen, Polyvinylchlorid, Polytetrafluorethylen, Polyacrylsäuremethylester, Polymethacrylsäuremethylester, Polycarbonate, Polyethylenglykol, Polyethylenterephthalat und Poly(organo)siloxane.

Bisher ist eine Querverknüpfung nur zwischen nicht metall-angebundenen Polymeren bekannt, wobei immer nur Polymere mit sich selbst eine Querverknüpfungsreaktion eingehen, also nur homoquerverknüpft werden. Demgegenüber wird erfindungsgemäß nur durch die Ausbildung einer Bindung an den Metallkomplex eine Querverknüpfung ausgelöst, wodurch die entsprechenden Polymere mit dem Metallkomplex hetero-querverknüpft werden.

Die Erfindung betrifft mit anderen Worten in einer Ausführungsform Materialien, insbesondere flüssig-prozessierbare optoelektronische Materialien, die durch ihren speziellen Aufbau gleichzeitig sowohl die kovalente Anbindung eines Metallkomplexes, beispielsweise eines hocheffizienten Emitter-Metallkomplexes, an einen entsprechend funktionalisierten zweiten Reaktanden in Form eines Polymers, als auch optional dessen Quervernetzung und somit Unlöslichkeitsmachung gewährleistet.

In einer bevorzugten Ausführungsform der Erfindung wird neben dem Metallkomplex, dem zweiten Reaktanden und optional dem dritten Reaktanden, ein vierter Reaktand in der ersten Reaktion des Verfahrens eingesetzt, wobei es sich um eine loch- oder elektronenleitende chemische Gruppe und/oder um eine ladungsblockierende chemische Gruppe handelt, die als Ladungstransport- bzw. Ladungsblockiereinheit ebenfalls quervernetzt werden kann. Beispiele für loch- oder elektronenleitende chemische Gruppen sind Arylamine wie N,N'-bis(naphthalen-1-yl)-N,N'-bis(phenyl)-benzidin, N,N'-bis(naphthalen-1-yl)-N,N'-bis(phenyl)-2,2'-dimethylbenzidin, Carbazole wie 4,4-Bis(carbazol-9-yl)biphenyl, 1,3-Bis(carbazol-9-yl)benzol, Benzimidazole wie 1,3,5-Tris(1-phenyl-1H-benzo[d]imidazol-2-yl)benzol, Oxadiazole wie 2-(4-Biphenyl)-5-(4-tert-butylphenyl)-1,3,4-oxadiazol, Triazole wie 3-(4-Biphenyl)-4-phenyl-5-tert-butylphenyl-1,2,4-triazol, 4-(Naphthalen-1-yl)-3,5-diphenyl-4H-1,2,4-triazol.

Zum Zwecke der Anbindung in an das Polymer und/oder den Metallkomplex weist der vierte Reaktand ebenfalls mindestens eine Ankergruppe der ersten und/oder zweiten Ankergruppenspezies auf, abhängig davon, ob der vierte Reaktand an den Metallkomplex oder den zweiten Reaktanden gebunden werden soll.

Für die erste Reaktion können dabei insbesondere solche im Stand der Technik als "Click-Chemie" bezeichnete, energetisch begünstigte Reaktionen verwendet werden, die spezifisch verlaufen und ein einzelnes Produkt ergeben (H. C. Kolb, M. G. Finn, K. B. Sharpless, Angew. Chem. Int. Ed. 2001, 40, 2004 -2021). Die "Click-Chemie" umfasst somit Reaktionen, die mit hohen Ausbeuten durchführbar sind, ein breites Anwendungsspektrum aufweisen, (stereo)spezifisch ablaufen, einfache Reaktionsbedingungen (möglichst unempfindlich gegen Wasser und Sauerstoff) aufweisen, einfach entfernbare, möglichst ungefährliche Nebenprodukte und Reagenzien (falls überhaupt) aufweisen, in umweltfreundlichen und/oder leichtentfernbaren Lösungsmitteln wie Wasser oder lösungsmittelfrei ablaufen und/oder eine einfache Aufreinigung (Extraktion, Phasentrennung, Destillation oder Kristallisation - möglichst keine Chromatographie) oder gar keine Aufreinigung benötigen.

"Click"-Reaktionen sind zumeist stark thermodynamisch begünstigt, mit oft mehr als 20 kcal mol⁻¹, was in schnellem Umsatz mit hoher Selektivität zu einem einzelnen Produkt resultiert. Mit Click-Reaktionen werden meist Kohlenstoff-Heteroatom Bindungen gebildet.

Insbesondere können nucleophile Substitutionen, besonders Ringöffnung von gespannten, elektrophilen Heterozyklen wie Epoxide und Aziridine, Carbonyl-Chemie des "Non-Aldol"-Typs wie die Bildung von aromatischen Heterocyclen oder Hydrazonen, Additionen an Kohlenstoff-Kohlenstoff-Doppelbindungen wie die oxidative Bildung von Epoxiden und Aziridinen, Dihydroxylierung und Michael-Additionen, sowie Cycloaddition an ungesättigte C-C-Bindungen, besonders 1,3-dipolare Cycloadditionen und Diels-Alder-Reaktionen gemäß der Erfindung verwendet werden. Weitere Beispiele für solche Reaktionen sind Kreuzkupplungsreaktionen zur Knüpfung von C-C-Bindungen wie die Ullmann-Reaktion, die Sonogashira-Reaktion und die Glaser-Kupplung. Alle diese Reaktionen sind dem Fachmann bekannt.

Für die Erfindung sind insbesondere solche Reaktionen bevorzugt, die ohne den Zusatz eines weiteren Reaktanden (also über den ersten, zweiten und ggf. dritten und ggf. vierten hinaus), dass heißt höchstens durch einen die weiter Anwendung nicht weiter störenden Katalysator auskommen. Beispiele für solche Reaktionen sind neben den oben erwähnten 1,3-dipolaren Cycloadditionen und Diels-Alder-Reaktionen Nitron-Alkin-, Nitriloxid-Alkin-, Thiol-En-, Thiol-In-, Thiol-Isocyanat, Tetrazol-Alken- und andere in der chemischen Literatur als Click-Reaktionen bekannte Verfahren.

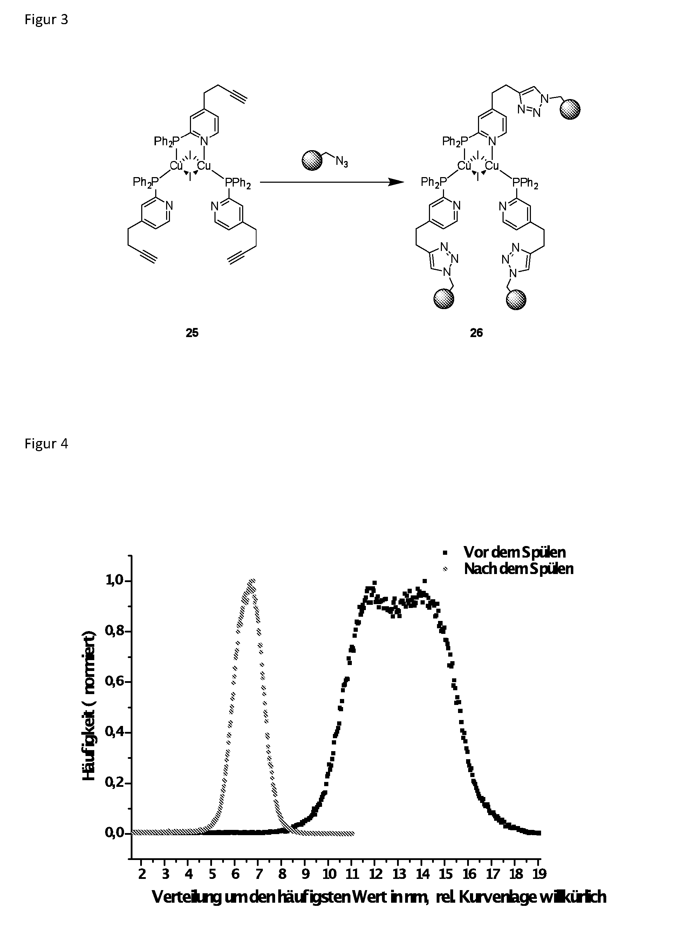

Wie eingangs beschrieben findet die erste Reaktion des Verfahrens in Gegenwart eines Katalysators zur Katalyse der Reaktion statt. Dabei weist der Metallkomplex den Katalysator auf, d. h. das im organischen Metallkomplex enthaltene Metallzentrum dient gleichzeitig als Katalysator, so dass eine autokatalysierte Bindung des Metallkomplexes an das Polymer stattfindet. Als Beispiel hierfür ist in Figur 3 die Kupfer-katalysierte Clickreaktion zwischen einem terminalen oder aktivierten Alkin als erster Ankergruppe einer ersten Ankergruppenspezies eines Metallkomplexes und einem Azid als Ankergruppe einer zweiten Ankergruppenspezies eines Polymers dargestellt.

Mittels eines Cu(I) Katalysators verläuft z. B. die klassische 1,3-dipolare Cycloaddition (Huisgen-Cyclisierung), die ansonsten recht hohe Temperaturen erfordert, regiounspezifisch verläuft und sich daher grundsätzlich nicht als "Click"-Reaktion eignet (V. V. Rostovtsev, et al., Angew. Chem. Int. Ed. 2002, 41, 2596-2599; C. W. Tornøe, et al., J. Org. Chem. 2002, 67, 3057) gegenüber der klassischen Cyclisierung bis zu 10⁷ mal schneller, regioselektiv (nur das 1,4-Regioisomer wird gebildet), auch in Wasser, bei Raumtemperatur und ist dabei unempfindlich gegenüber den meisten anderen funktionellen Gruppen, wie beispielsweise Alkoholen, Säuren und Säurederivaten, Carbonylverbindungen, Halogenen etc.

In einer bevorzugten Ausführungsform ist der Metallkomplex ein Cu(I) oder Cu(II)-Komplex, so dass die Reaktion autokatalytisch erfolgt. Andere mögliche Katalysatoren als Teil des Metallkomplexes sind Re, Fe, Ru, Os, Co, Rh, Ir, Ni, Pd, Pt, Ag, Au, Zn, Cd, Hg, Sn und/oder Pb.

Die Reaktion zwischen Metallkomplex und zweitem Reaktanden verläuft bevorzugt bei einer Temperatur, die größer ist als Raumtemperatur. Bevorzugt sind mindestens 50 °C, besonders bevorzugt sind Temperaturen von 80 °C bis 120 °C. Die für die jeweilige Reaktionstemperatur benötigte Reaktionszeit kann von einem Fachmann leicht bestimmt werden. Im Allgemeinen ist mit einer Reaktionszeit von 1 Minute bis 60 Minuten, bevorzugt von 10 Minuten bis 30 Minuten zu rechnen, so dass der Metallkomplex immobilisiert und damit stabilisiert und unlöslich ist. Die thermische Aktivierung kann dabei auch durch Bestrahlung mit Mikrowellen erfolgen, wodurch die Reaktionszeiten meist deutlich verkürzt auf kleiner als 1 Minute werden können.

Ist eine Ankergruppe, z. B. ein Alkin-Linker, in Konjugation zu einem organischen Liganden des Metallkomplexes vorhanden und wird ein aromatisches Azid als komplementäre Ankergruppe verwendet, so lassen sich die Emissionsfarben solcher emittierender Komplexe, die auf Charge-Transferübergängen zwischen den Metallionen und den Liganden beruhen, beeinflussen. Bevorzugt sind in diesem Zusammenhang Metallkomplexe mit drei Liganden oder mehr (z. B. vier, fünf oder sechs Liganden), da damit drei Anknüpfstellen oder mehr (z. B. vier, fünf oder sechs Anknüpfungsstellen) vorhanden sind. Somit lassen sich die Komplexe auf diese Weise sowohl an die Polymere anknüpfen, als auch mit Loch- oder Elektronenleitern (vierten Reaktanden) verbinden. Die optischen, mechanischen und elektrischen Eigenschaften der so erhaltenen Substanzen lassen sich damit über die jeweilige Zusammensetzung des Azid-Gemisches beeinflussen.

Sofern das hier beschriebenen Verfahren gemäß einer bevorzugten Ausführungsform der Erfindung zu einem unlöslichen Produkt führt ist es möglich, mehrere Schichten immobilisierter Metallkomplexe in einfacher Weise übereinander anzuordnen, ohne dass z. B. orthogonale Lösungsmittel verwendet werden müssen.

Zur Herstellung einer Mehrschichtanordnung wird nach der oben beschriebenen ersten Reaktion eine zweite Reaktion durchgeführt. Diese zweite Reaktion umfasst einen fünften Reaktanden in Form eines organischen Metallkomplexes und einen sechsten Reaktanden zur Ausbildung eines bevorzugt unlöslichen mehrdimensionalen Netzwerkes, wobei der Metallkomplex während der zweiten Reaktion in dem sich bildenden mehrdimensionalen Netzwerk querverknüpft wird. Hinsichtlich spezieller Ausgestaltungen der zweiten Reaktion gilt das für die erste Reaktion gesagte entsprechend.

Dabei kann der fünfte Reaktand der zweiten Reaktion zu dem ersten Reaktanden der ersten Reaktion identisch oder verschieden sein. Ebenso kann der sechste Reaktand der zweiten Reaktion zu dem zweiten Reaktanden der ersten Reaktion identisch oder verschieden sein.

Die gemäß einer bevorzugten Ausgestaltung des Verfahrens erfolgende Quervernetzung erlaubt eine schnelle und einfache Anordnung beliebig vieler photoaktiver Schichten, deren Löslichkeit nicht wie in bisherigen Systemen exakt aufeinander abgestimmt werden müssen. Dies hat eine deutliche Vereinfachung in der Verarbeitung zur Folge, da die Auswahl der einzelnen aktiven Schichten nicht mehr bezüglich der Löslichkeit zueinander orthogonal sein muss, sondern nahezu unabhängig voneinander kombiniert werden kann. Dies erlaubt somit die sequentielle Auftragung beliebig vieler unterschiedlicher Schichten und führt dadurch zu einer signifikanten Verbesserung der Effizient und Haltbarkeit.

In einer bevorzugten Ausgestaltung des Verfahrens sind die Ankergruppen der ersten und zweiten Ankergruppenspezies in jeweils äquimolaren Mengen vorhanden, so dass alle Ankergruppen kovalente Bindungen mit komplementären Ankergruppen eingehen können.

In einem zweiten Aspekt betrifft die Erfindung die Verwendung des mittels des hier beschriebenen Verfahrens erhaltenen Polymers, insbesondere als Emitter oder Absorber in einem optoelektronischen Bauelement.

Insbesondere in Fällen, in denen der Metallkomplex ein Emitter-Metallkomplex ist, der in optoelektronischen Bauelementen eingesetzt werden kann und soll, besteht ein Vorteil der Erfindung in der Stabilisierung der Geometrie des Emitter-Metallkomplexes durch die Immobilisierung der Quervernetzung.

Es ist bekannt, dass eine Änderung der Geometrie eines Emitterkomplexes bei der Anregung aus dem Grundzustand in den ersten angeregten Zustand zu größeren Verschiebungen der Energiepotentiale und zu größeren Wahrscheinlichkeiten für nicht-strahlende Relaxationsprozesse führt. Die Geometrie des angeregten Zustands sollte sich daher nicht von derjenigen des Grundzustands unterscheiden. Die mit der Erfindung erreichte räumliche/sterische Stabilisierung von Emittern führt somit zu einer Effizienzsteigerung von Emittern als Metallkomplexe.

Mittels der in der Peripherie der Liganden der als Metallkomplexe, z. B. als Emitterkomplexe, angebundenen Ankergruppen für die verknüpfenden Click-Reaktionen wird die mögliche Bewegung der Liganden des Metallkomplexes zueinander eingeschränkt. Die Komplexe werden somit fixiert und stabilisiert. Die Übergangswahrscheinlichkeiten für nicht strahlende Prozesse werden im Gegensatz zu "freien" Komplexen durch Rotation und Verdrillung reduziert: Die Emissions-Quantenausbeute der Emitter werden erhöht. Gleichzeitig führt die Fixierung zu einer maximalen Ausnutzung des energetischen Abstandes zwischen Grund- und erstem angeregten Zustand. Hierdurch kann im Vergleich zum "freien", d. h. nicht quervernetzten Komplex eine Blauverschiebung des Emissionsspektrums stattfinden, da die Besetzung von Rotations- und Schwingungszuständen weniger wahrscheinlich und der Energieunterschied zwischen Grund- und erstem angeregten Zustand (direkte vertikale Anordnung der Potentialkurven, vgl. Franck-Condon-Prinzip, das dem Fachmann bekannt ist) maximiert wird.

Neben der Schichtstabilisierung und dem möglichen Einbau von definierten Loch- und Elektronenleitern verbessert die Erfindung darüber hinaus die Effizienz von optoelektronischen Bauteilen: Durch die sterische Hinderung der Metallkomplexe werden die Überlappintegrale zwischen nicht zur Emission genutzten Zuständen kleiner, die Besetzung von Rotations- und Schwingungszuständen weniger wahrscheinlich. Die Stabilität der Komplexe steigt durch die Verhinderung von Bindungsbrüchen und nicht-strahlenden Relaxationen durch freie Beweglichkeit der Liganden eines Metall-Emittersystems. Durch die Immobilisierung ist es möglich, die Emission eines gegebenen freien, also nichtvernetzten emittierenden Metallkomplexes in Richtung des oder in den blauen Spektralbereich zu verschieben.

In einem dritten Aspekt betrifft die Erfindung die Verwendung eines gemäß dem hier beschriebenen Verfahrens hergestellten Polymers mit kovalent angebundenem Metallkomplex als Emitter oder Absorber in einem optoelektronischen Bauelement, sofern der Metallkomplex ein Licht-Emitter oder -Absorber ist.

Entsprechend betrifft die Erfindung in einem vierten Aspekt auch ein optoelektronisches Bauelement, aufweisend einen an ein Polymer kovalent gebundenen organischen Metallkomplex, wie hier beschrieben.

Das optoelektronische Bauelement kann eine organischen Leuchtdiode (OLEDs), lichtemittierenden elektrochemischen Zelle (LEECs oder LECs), OLED-Sensoren, optischen Temperatur-Sensoren, organischen Solarzellen (OSCs), organischen Feldeffekttransistoren, organischen Dioden, organischen Photodioden und "down conversion" Systeme betreffen. Derartige Bauelemente sind dem Fachmann bekannt.

In einem fünften Aspekt betrifft die Erfindung ein Verfahren zur Herstellung einer Schicht eines an ein Polymer gebundenen organischen Metallkomplexes, insbesondere einer dünnen Schicht mit einer Dicke von 75 nm bis 300 nm, insbesondere von 100 nm bis 250 nm, insbesondere zur Herstellung eines optoelektronischen Bauelements.

Das Verfahren ist abhängig davon, ob der Metallkomplex einseitig oder mindestens zweiseitig an das Polymer gebunden wird. Im ersten Fall erfolgt eine Flüssigprozessierung des Reaktionsproduktes, da die Löslichkeit des Metallkomplexes durch die Bindung an das Polymer erhöht wird. Im zweiten Fall kann das Auftragen eines Gemisches beider Reaktanden auf einen festen Träger mittels aller im Stand der Technik bekannter Methoden erfolgen, insbesondere mittels Inkjet-Printing, Dipping, Spincoating, Schlitzgießen oder Rakeln (Knife Coating). Das Reaktionsprodukt ist unlöslich.

Im ersten Fall kann die weitere Flüssigprozessierung des somit erhaltenen Kompositmaterials mittels aller im Stand der Technik bekannter Beschichtungs- und Druckverfahren erfolgen, insbesondere mittels Inkjet-Printing, Dipping, Spincoating, Schlitzgießen oder Rakeln (Knife Coating).

Im ersten Fall weist das Verfahren mindestens die folgenden Schritte auf: Zunächst wird ein Gemisch aus einem ersten Reaktanden in Form eines organischen Metallkomplexes und einem zweiten Reaktanden in Form eines Polymers in Lösung hergestellt. Gängige dabei verwendete organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol und Tetrahydrofuran.

Der Metallkomplex wird während der dann durchgeführten ersten Reaktion an das Polymer einseitig gebunden, bzw. in einer bevorzugten Ausgestaltung, wie oben beschrieben, mehrseitig gebunden (quervernetzt). Dabei wird die Reaktion zwischen dem ersten Reaktanden und dem zweiten Reaktanden durch den Metallkomplex katalysiert.

Wie hierin beschrieben erfolgt die Ausbildung der einseitigen oder mindestens mehrseitigen Anbindung bevorzugt bei erhöhter Temperatur, bevorzugt zwischen 80 °C bis 120 °C.

In einem sechsten Aspekt betrifft die Erfindung die Verwendung eines an ein Polymer gebundenen Metallkomplexes als Emittermaterial für ein optoelektronisches Bauelement, insbesondere als optoelektronische Tinte.

In einem siebenten Aspekt betrifft die Erfindung einen organischen Metallkomplex mit mindestens einem Metallzentrum und mindestens einem organischen Liganden. Erfindungsgemäß weist der Metallkomplex eine, bevorzugt zwei, drei, vier, oder mehr Ankergruppen einer ersten Ankergruppenspezies zur Reaktion mit einer Ankergruppe einer zweiten Ankergruppenspezies zur einseitigen oder mehrseitigen Anbindung auf, wobei die Ankergruppe des Metallkomplexes während einer ersten Reaktion zu der Ankergruppe eines zweiten Reaktanden, eine kovalente Bindung ausbilden kann.

In einem achten Aspekt betrifft die Erfindung die Verwendung eines derartigen Metallkomplexes zur Anbindung und optional Quervernetzung und somit Immobilisierung des Metallkomplexes mit einem zweiten Reaktanden, insbesondere in Form eines Polymers, der eine Ankergruppe einer zweiten Ankergruppenspezies aufweist. Gleichzeitig betrifft die Erfindung die Verwendung eines Polymers zur Verbesserung der Löslichkeit eines Metallkomplexes bei der hier beschriebenen einseitigen Anbindung.

In einem neunten Aspekt betrifft die Erfindung ein Verfahren zur Funktionalisierung eines organischen Metallkomplexes mit ein, zwei, oder mehr Ankergruppen, über die der Metallkomplex durch Bindung an einen eine zweite Ankergruppe tragenden zweiten Reaktanden gebunden und optional (bei mindestens zweiseitger Bindung) immobilisiert werden kann, da die Ankergruppe(n) einer ersten Ankerguppenspezies des Metallkomplexes (jeweils) mit der Ankergruppe einer zweiten Ankergruppenspezies des zweiten Reaktanden reagieren und so eine kovalente Bindung ausbilden kann.

### Figuren

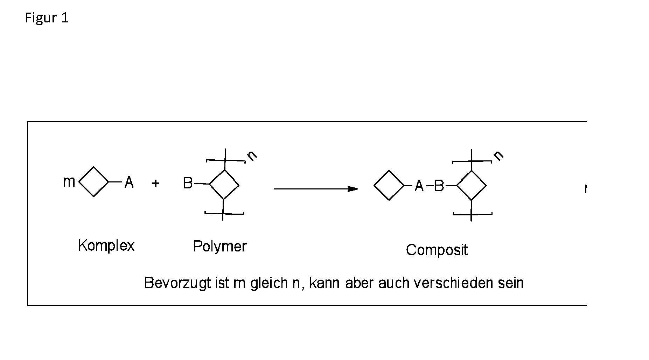

- Figur 1:: Allgemeines Schema für die Verknüpfung von organischen Metallkomplexen (erster Reaktand) mit einem Polymeren (zweiter Reaktand), die jeweils eine entsprechende Ankergruppen tragen, die die Bindung bzw. optional Quervernetzung des Metallkomplexes ermöglichen.
- Figur 2:: Ausgewählte Beispiele für Ankergruppen einer ersten und zweiten Ankergruppenspezies (jeweils in Zeilen angeordnet). Jeweils gegenüberliegend gezeigte Ankergruppen können, gebunden einerseits an den Metallkomplex und andererseits an den zweiten Reaktanden, eine kovalente Bindung zwischen den Reaktanden ausbilden und den Metallkomplex so anbinden und ihn ggf. immobilisieren. Erste und zweite Ankergruppenspezies werden hier als Anker A bzw. Anker B angesprochen. Dabei kann je nach Verwendung der hier dargestellte Anker A die erste oder zweite Ankergruppenspezies, und der Anker B entsprechend die zweite oder erste Ankergruppenspezies darstellen.
- Figur 3:: Reaktion für die Vernetzung eines Alkin-substituierten Kupferkomplexes mit einem polymeren Azid als zweitem Reaktanden, wobei die Reaktion autokatalysiert abläuft. Die gezeigte Kugel steht für Polystyrol als Beispiel für einen zweiten Reaktanden.
- Figur 4:: Histogramm des AFM-Bildes vor und nach dem Spülen mit Xylol (s. Beispiel 3). Die Höhen sind auf 1 normiert, die Lage der Histogramme auf der X-Achse willkürlich, aber maßstabsgetreu. Zur besseren Übersicht wurden die Histogramme nicht über einander, sondern nebeneinander angeordnet. Die Prozessierung erfolgte bei 40 °C, die Scan-Größe der zugrundeliegenden Aufnahmen beträgt 1 µm².

### Beispiele

Die Erfindung besteht in einem Stabilisierungs-, Anbindungs- und optional Vernetzungsverfahren von Metallkomplexen durch Polymere, die aus einem oder mehreren Metallen und einem mindestens zweizähnigen, oder mehreren ein- oder mehrzähnigen Liganden bestehen. Erfindungsgemäß tragen der organische Metallkomplex und der zweite Reaktand komplementäre chemische Anker einer (ersten bzw. zweiten) Ankergruppenspezies, die in einer möglichst schnell und vollständig ablaufenden Reaktion kovalent miteinander verbunden werden. So können beispielsweise lumineszierende oder halbleitende Metallkomplexe z. B. für Anwendungen in der organischen Elektronik immobilisiert werden, um die Lebensdauer und Langzeitstabilität der entsprechenden Bauteile zu erhöhen.

### Beispiel 1

Für die beschriebene Erfindung sind solche Reaktionen bevorzugt, die neben dem Metallkomplex und dem zweiten Reaktanden ohne den Zusatz eines weiteren Reaktanden, dass heißt höchstens durch einen die Anwendung nicht weiter störenden Katalysator, auskommen. Beispiele für solche Reaktionen sind 1,3-dipolaren Cycloadditionen, Diels-Alder-Reaktionen, Nitron-Alkin-, Nitriloxid-Alkin-, Thiol-En-, Thiol-In-, Thiol-Isocyanat, Tetrazol-Alken- und andere in der chemischen Literatur als Click-Reaktionen bekannte Verfahren.

Es handelt sich um Reaktionen, die von dem im Metallkomplex enthaltenen Metall selbst katalysiert werden, was einer autokatalysierten Anbindung oder Quervernetzung entspricht. Ein Beispiel hierfür ist die Kupfer-katalysierte Clickreaktion zwischen einem terminalen oder aktivierten Alkin und einem Azid. Diese Reaktion liefert regioselektiv und in hohen Ausbeuten und Umsätzen 1,4-Triazole (s. Figur 2).

### Beispiel 1.1.: Cu-Komplex katalysierte Clickreaktion zwischen terminalen Alkinen und Aziden:

Phenylacetylen (103 mg, 1.0 mmol, 1.0 Äquiv.) und Benzylazid (133 mg, 1.0 mmol, 1.0 Äquiv.) wurden in einem mit einem Septum luftdicht verschließbaren Vial in 10 mL trockenem Dichlormethan gelöst. Der Cu-Komplex (katalytische oder stöchiometrische Mengen) wurde zugegeben, das Vial versiegelt und die Reaktion 2 Tage bei Raumtemperatur gerührt. Zum Entfernen des Katalysator-Komplexes wurde die Reaktionsmischung in 50 mL Methanol gegeben und 20 min gerührt. Der Komplex wurde abfiltriert und das Filtrat eingeengt. Entfernen des Lösungsmittels und Trocknen des Produkts im Hochvakuum ergab die Verbindung 1-Benzyl-4-phenyl-1H-1,2,3-triazol als hellgelben Feststoff in 95 % Ausbeute (245 mg, 0.95 mmol). Die Identität des Produkts wurde eindeutig durch NMR-Spektroskopie, Infrarotspektroskopie und hochauflösende Massenspektrometrie belegt.

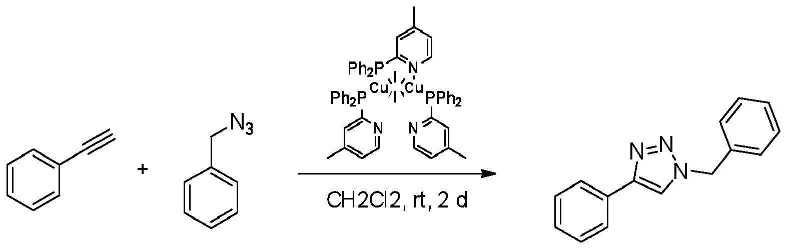

### Beispiel 1.2.: Cu-Komplex katalysierte Clickreaktion zwischen Cu-Alkin-Komplex und Aziden:

Der Cu-Komplex (1,341 g, 1.0 mmol, 1,0 Äquiv.) wurde in einem mit einem Septum luftdicht verschließbaren Vial in 10 mL trockenem Dichlormethan gelöst und Benzylazid (466 mg, 3,5 mmol, 3,5 Äquiv.) zugegeben. Die Reaktion wurde 12 Stunden lang bei Raumtemperatur gerührt, über einen Spritzenfilter filtriert und durch Eintropfen in Diethylether ausgefällt. Waschen des ausgefällten Feststoffs mit Diethylether und Trocknen des Produkts im Hochvakuum ergab die Verbindung Tris-(4-(2-(1-benzyl-1H-1,2,3-triazol-4-yl)ethyl)-2-(diphenylphosphino)pyridin)-di-kupfer-diiodid als hellgrünen Feststoff in 61 % Ausbeute (1,052 g, 0,61 mmol). Die Identität des Produkts wurde eindeutig durch NMR-Spektroskopie, Infrarotspektroskopie, Massenspektrometrie und Elementaranalyse belegt.

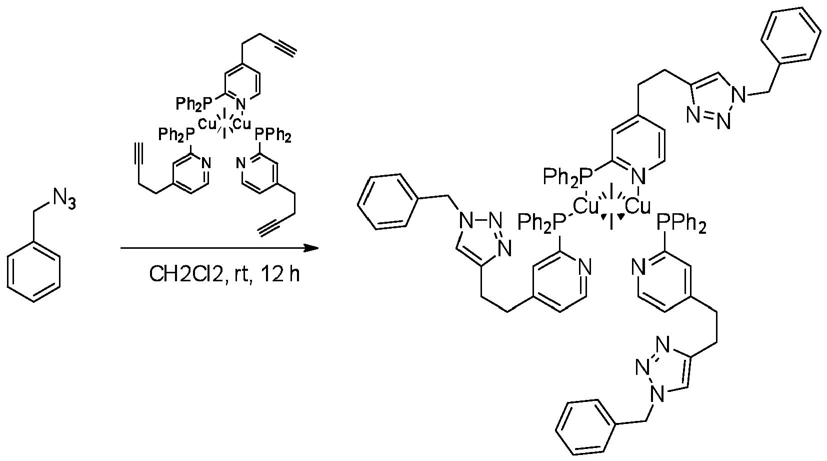

### Beispiel 1.3. Cu-Komplex katalysierte Clickreaktion zwischen Cu-Alkin-Komplex und Polyaziden zur Querverknüpfung:

Der Cu-Komplex (440 mg, 0.33 mmol, 1.0 Äquiv.) wurde als erster Reaktand in einem mit einem Septum luftdicht verschließbaren Vial in 10 mL trockenem Dichlormethan gelöst und mit Poly-(vinylbenzylazid-alt-styrol) (370 mg, 1,0 mmol, 3,0 Aquiv.) umgesetzt. Die Reaktion wurde 12 Stunden lang bei Raumtemperatur gerührt, wobei das Produkt als unlöslicher grünlicher Feststoff aus der Reaktionslösung ausfiel. Der Niederschlag wurde abgesaugt, mit 20 mL Dichlormethan, 20 mL Diethylether und 20 mL Methanol gewaschen und im Hochvakuum getrocknet. Das Produkt Poly-(4-(2-(1-(4-vinylbenzyl-1H-1,2,3-triazol-4-yl)ethyl)-2-(diphenylphosphino)pyridin)-alt-styrol @ CuI fiel als hellgrüner Feststoff in 66 % Ausbeute an (540 mg, 0,21 mmol) und stellt den quervernetzten Metallkomplex dar. Die Identität des Produkts wurde eindeutig durch Infrarotspektroskopie und Elementaranalyse belegt.

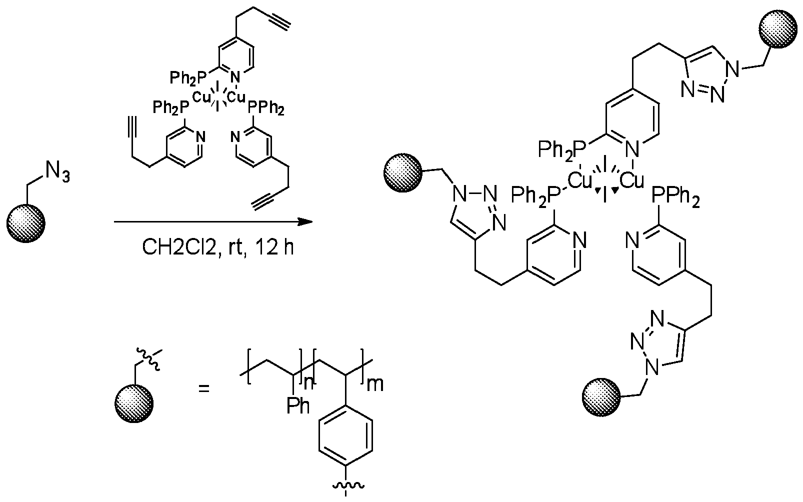

Es wurde gezeigt, dass eine solche Reaktion unlösliche, quervernetzte Metallkomplexe (KompositMaterialien) liefert. Sowohl der Ausgangskomplex 25 als auch das Produkt 26 (s. Figur 2). verfügen dabei über eine gelbe Lumineszenz, deren Spektrum durch die Reaktion nicht weiter beeinflusst oder gestört wird, da die Ankergruppen nicht in Konjugation zum Emittersystem stehen.

Nach dem Auftragen auf einen Objektträger mit einer Rakel-Apparatur (alle weiteren bekannten Druck- oder Beschichtungsverfahren wie bspw. Spincoating, Schlitzgießen oder Ink-Jet sind ebenfalls möglich) zu einer dünnen Schicht und einem Aushärten durch 30-minütiges Erhitzen auf 100 °C wurde diese Schicht stabilisiert und unlöslich. Mit einem derartigen Verfahren lassen sich auf einfachem Wege Mehrschichtanordnungen realisieren, für deren Umsetzung ansonsten orthogonale Lösungsmittel oder photochemische Aushärtungsschritte benötigt werden. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.

### Beispiel 2

Die Erfindung betrifft in einer bevorzugten Ausführungsform die Herstellung von neuartigen optoelektronischen Tinten als Emittermaterial für organische Leuchtdioden als optoelektronisches Bauelement. Die Tinte beruht dabei in einer Ausführungsform auf elektrolumineszierenden Kupfer(I)-Komplexen, bei denen Diphenylphosphinpyridine, Diphenylphosphinchinoline und verwandte Heterozyklen als Liganden verwendet werden. Diese zweizähnigen Liganden bilden mit Kupfer(I)-iodid mehrkernige Komplexe mit einem Ligand-Metalliodid-Verhältnis von 3:2.

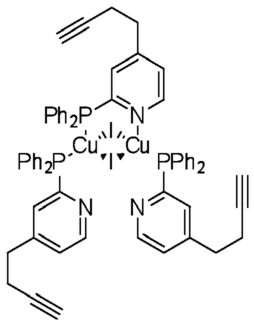

Struktur von Tris-(4-Butinyl-2-diphenylphosphinopyridin)-bis-(kupferiodid)

Wie in Versuchen gezeigt wurde, lassen sich diese Ligandensysteme mit Alkin-Ketten wie 4-Butin substituieren und als Kupferkomplex (erster Reaktand mit erster Ankergruppe) in einer *Click-*Reaktion mit Aziden kuppeln. Mit dieser Reaktion lassen sich sowohl niedermolekulare als auch polymere Azide als zweiter Reaktand umsetzen, so dass beispielsweise vernetzte, Kupfer-haltige Polymere synthetisiert werden können, die die elektrolumineszierenden Eigenschaften der Metallkomplexe mit den Vorteilen der einfachen flüssigen Verarbeitbarkeit der Polymere verbinden und nach einem Temperschritt robuste, unlösliche Schichten ergeben. Im Falle der einseitigen Anbindung können die Vorteile einer flüssigen Prozessierung der hierdurch entstehenden löslichen Metallkomplex-Polymer-Kompositmaterialien (kurz Kompositmaterialien) genutzt werden, bei mehrseitiger Anbindung ergeben sich quervernetzte unlösliche Schichten zur Realisierung von Mehrschichtaufbauten.

Weiterhin kann diese Reaktion auch mit weiteren Ligandenklassen durchgeführt werden. Gleichzeitig können neben der Anbindung oder Quervernetzung weitere Materialfunktionen in die Tinte implementiert werden. Dafür können Click-Reaktionen genutzt werden, um funktionelle Halbleiter (als dritter Reaktand), die lochleitende beziehungsweise elektronenleitende Eigenschaften haben, an die Komplexe zu knüpfen. Wird die Ankergruppe, z. B. der Alkin-Linker, in Konjugation zu den organischen Liganden angeknüpft und aromatische Azide verwendet, so lassen sich die Emissionsfarbe der Komplexe, die auf Charge-Transferübergängen zwischen den Metallionen und den Liganden beruht, beeinflussen. Da die dimeren Komplexe jeweils drei Liganden und damit drei Anknüpfstellen enthalten, lassen sich die Komplexe auf diese Weise sowohl an die Polymere anknüpfen, als auch mit Loch- oder Elektronenleitern verbinden. Die optischen, mechanischen und elektrischen Eigenschaften der so erhaltenen Substanzen lassen sich damit über die jeweilige Zusammensetzung des Azid-Gemisches beeinflussen. Über Roboter-gestützte High-Throughput-Screening-Verfahren lassen sich diese Parameter der Tinte optimieren. Bei der Verwendung verschiedener mit Alkin substituierter Metallkomplexe lassen sich so organische Leuchtdioden in verschiedenen Farben realisieren, durch geeignete Farbmischung der entsprechenden Metallkomplexe können so Weißlicht-OLEDs erzeugt werden.

So lassen sich die Emitter mit einer optimalen Mischung aus Lochleitern, Elektronenleitern und einem Polymer zu einer optoelektronischen Tinte verknüpfen.

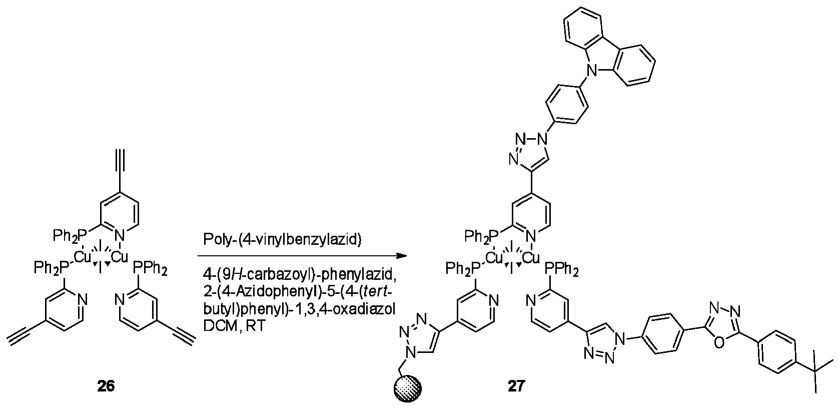

Die in **27** gezeigte Kugel steht für Polystyrol, kann aber jedes andere Polymer als zweiten Reaktanden repräsentieren.

Dabei dient der PyrPHOS-Komplex (Pyridyldiphenylphosphin = PyrPHOS) selbst als Katalysator für die Click-Reaktion. Bei Verwendung von polymeren Aziden mit einem Rückgrat aus Polystyrol oder Polyethylenglykol tritt durch Reaktion über nur eine Ankergruppe des Metallkomplexes eine einseitige Anbindung auf.

Wie durch Photolumineszenz-Spektroskopie gezeigt werden konnte, wird die gelbe Emissionsfarbe der Kupfer-PyrPHOS-Komplexe weder durch Variation der Ladungstransport- oder Blockiereinheiten, noch durch die Anknüpfung an die Polymere beeinflusst. Das Emissionsmaximum der PyrPHOS-Systeme liegt bei 550 nm. Dass sich die per Photolumineszenz beobachtete Emissionsfarbe auch im OLED reproduzieren lässt, wurde in einer Einschichtanordnung durch Mischen des Kompositmaterials mit dem Lochleiter CBP gezeigt.

### Beispiel 3

### Auftragen mit der Rakel (Knife Coating):

Mit dem Rakel-Verfahren lassen sich dünne Schichten mithilfe eines keilförmigen Beschichtungsmessers herstellen. Dazu wird die Substanz in Lösung auf das Substrat aufgetragen und durch einen Schlitten, der mit einer definierten Spaltbreite und Zuggeschwindigkeit gesteuert werden kann, gleichmäßig verteilt. Durch Beheizen und einen Stickstoffstrom werden die so erzeugten Filme getrocknet, so dass extrem glatte, definierte Schichten erzeugt werden können.

Zur Herstellung der dünnen Schichten wurde das in Xylol gelöste Polymer mit dem in Dichlormethan gelösten Metallkomplex in einem Vial gemischt und nach einer kurzen Zeit nach dem Zusammengeben als leicht getrübte Lösung auf ein mit Indiumzinnoxid (ITO) und PEDOT:PSS beschichtetes Substrat aufgetragen. Es wurde eine äquimolare Stöchiometrie gewählt.

Die Reaktion, Beschichtung und Trocknung wurden bei verschiedenen Temperaturen durchgeführt. Da der gesamte Prozess nach sehr kurzer Zeit beendet war, wurden die Proben anschließend für eine Stunde auf einer Heizplatte bei 100 °C getempert, um einen möglichst hohen Umsatz der Huisgen-Reaktion zu erreichen. Die Proben wurden unter einer UV-Lampe sowie per Rasterkraftmikroskopie untersucht. Außerdem wurden zur Reaktionskontrolle die Filme vor und nach dem Trocknen durch Eintauchen in Xylol gespült. Während das vernetzte Produkt unlöslich ist, lösen sich die Edukte in diesem Lösemittel, sodass durch die Beständigkeit der Schichten eine Aussage über eine erfolgreiche Quervernetzung möglich ist.

Mit zunehmender Prozesstemperatur stieg auch die Spülbeständigkeit. Nach dem Temperschritt waren alle getesteten Schichten beständig gegen Xylol. Die verschiedenen Proben wurden per AFM (Rasterkraftmikroskop) vermessen, um die Morphologie der Schichten auf nanoskaliger Ebene zu untersuchen.

Durch Rasterkraftmikroskopie konnte der durch optischen Vergleich gewonnene Eindruck, dass sich die Eigenschaften der quervernetzten Proben durch das Spülen nicht mehr verändern lässt, bestätigt werden. Zusätzlich wurde die Rauigkeit R_{q}(Standardabweichung der Höhenverteilungskurve) bestimmt (gemäß E. P. Degarmo, J. T. Black, R. A. Kohser, Materials and Processes in Manufacturing, 2003, 9. Auflage, Wiley, 223). Dazu wurden die gesamte Scanfläche oder bei Verunreinigungen ein Ausschnitt davon ausgewählt. Die Ergebnisse sind in der nachstehendenTabelle 1 aufgeführt.

Die Rauigkeit ist für die gemessenen Proben mit Werten zwischen 0,53 und 1,64 nm sehr niedrig, was für eine exzellente Morphologie der gemessenen Proben spricht.

**Tabelle 1: Rauigkeit der AFM-Proben. In den ersten vier Proben zeigten sich Pinholes, die Bestimmung erfolgte daher nicht über den gesamten Messbereich, sondern über einen loch-freien Bereich, um repräsentative Ergebnisse zu erhalten.**

| **Probe** | | | **Rauigkeit R_{q}** | **Bezogen auf eine Fläche von** |
|---|---|---|---|---|
| **80** | 11 °C | | 0.66 nm | 0.478 µm² |
| **80** | 11 °C | gespült | 0.99 nm | 0.397 µm² |
| **81** | 25 °C | | 0.53 nm | 0.485 µm² |
| **81** | 25 °C | gespült | 0.70 nm | 0.495 µm² |
| **82** | 40 °C | | 1.64 nm | 1.000 µm² |
| **82** | 40 °C | gespült | 0.91 nm | 1.000 µm² |

In Figur 4 sind zum Vergleich Histogramme gezeigt. Demnach ergeben sich recht scharfe, nahezu Gauß-förmige Höhenverteilungen. Die Standardabweichung dieser Verteilungskurven ist in Tabelle als R_{q} angegeben.

### Beispiel 4

### Gleichzeitige einseitig Anknüpfung des Metallkomplexes

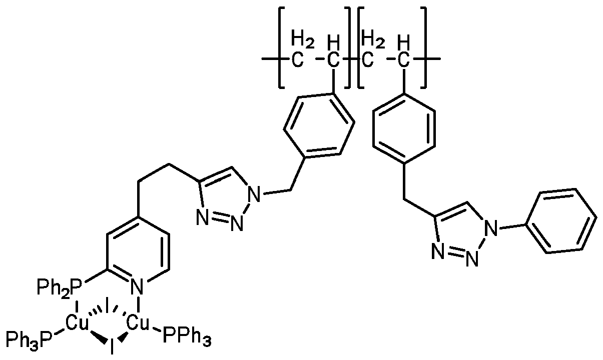

Um auf einfache, modulare Weise sowohl Kupferkomplexe (als erster Reaktand) als Emitter, als auch Ladungstransport-Einheiten (als dritter Reaktand) in ein Polymer (als zweiter Reaktand) zu bringen, wurde der Metallkomplex, ein Überschuss Azid und Phenylacetylen umgesetzt. Es wurden beide Alkine ans Polymer geknüpft. Außerdem luminesziert das Produkt wie erwartet, der Komplex bleibt also intakt.

### Beispiel 5

### Cu(I)-Katalyse mit den PyrPHOS-Komplexen

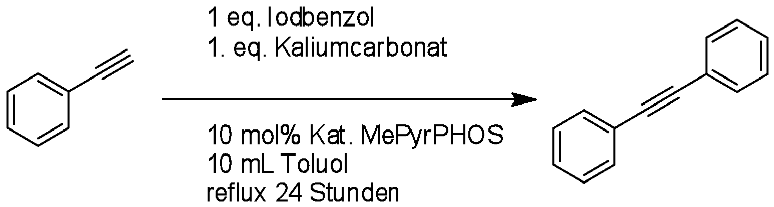

Einerseits soll das katalytische Potential der PyrPHOS-Systeme über die Cu(I)-Huisgen-Reaktion hinaus evaluiert werden. Mit den unlöslichen, quervernetzen PyrPHOS-Polymeren könnte somit ein Festphasen-Katalysator mit immobilisiertem Cu(I) vorliegen.

Andererseits können mit derartigen Reaktionen die Eigenschaften der Metallkomplexe modifiziert werden, z. B.:

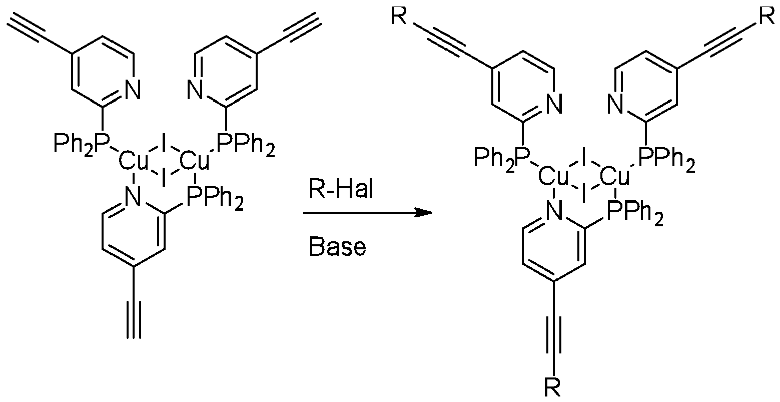

Die oben gezeigte Reaktion lief mit vollständigem Umsatz (mittels IGC-MS bestimmt) ab, außerdem konnte der in Toluol unlöslich Katalysator mit dem Kaliumcarbonat abfiltriert werden und blieb intakt (Erhalt der gelben Photolumineszenz).

### Beispiel 6

### Thiol-En-Reaktion

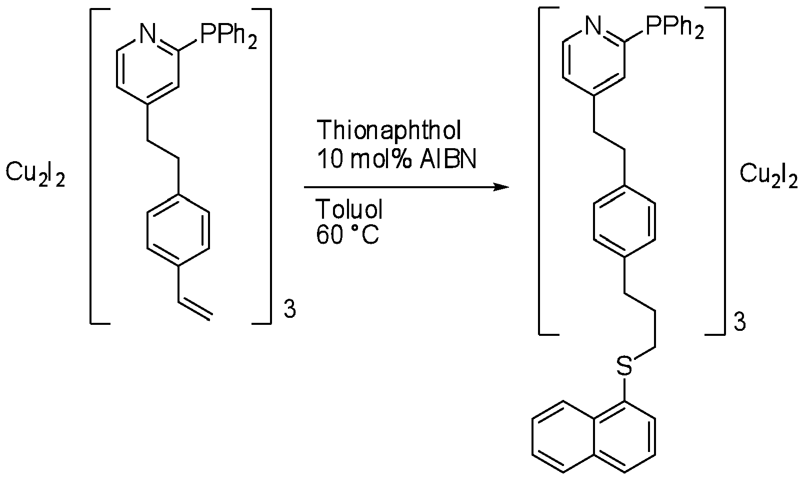

Das rechts gezeigte Produkt luminesziert wie das links gezeigte Edukt. Der typische Geruch eines freien Thiols war nach der Reaktion nicht mehr vorhanden.

## Patentansprüche

1. Verfahren zur kovalenten Bindung eines organischen Metallkomplexes mit mindestens einem Metallzentrum und mindestens einem organischen Liganden an ein Polymer,
umfassend das Durchführen einer ersten Reaktion, die aufweist
- einen ersten Reaktanden in Form eines organischen Metallkomplexes und
- einen zweiten Reaktanden in Form eines Polymers,
wobei während der Reaktion der Metallkomplex kovalent an das Polymer gebunden wird,
**dadurch gekennzeichnet, dass**
die Reaktion durch den Metallkomplex katalysiert wird.

2. Verfahren nach Anspruch 1, wobei das Metallzentrum des Metallkomplexes ausgewählt ist aus der Gruppe bestehend aus Re, Fe, Ru, Os, Co, Rh, Ir, Ni, Pd, Pt, Cu, Ag, Au, Zn, Cd, Hg, Sn und Pb.

3. Verfahren nach Anspruch 1 oder 2, wobei
- der Metallkomplex eine Ankergruppe einer ersten Ankergruppenspezies zur kovalenten Bindung des Metallkomplexes an das Polymer aufweist und
- der zweite Reaktand eine Ankergruppe einer zweiten Ankergruppenspezies zur kovalenten Bindung an den Metallkomplex aufweist, und wobei
die kovalente Bindung des Metallkomplexes an das Polymer durch Reaktion der Ankergruppe des Metallkomplexes mit der Ankergruppe des zweiten Reaktanden erfolgt.

4. Verfahren nach Anspruch 1 oder 2, wobei
- der Metallkomplex eine Ankergruppe einer ersten Ankergruppenspezies zur kovalenten Bindung des Metallkomplexes an das Polymer mittels einer Ankergruppe einer zweiten Ankergruppenspezies aufweist und
- der zweite Reaktand eine erste Ankergruppe einer ersten Ankergruppenspezies zur kovalenten Bindung des zweiten Reaktanden an eine Ankergruppe einer zweiten Ankergruppenspezies aufweist, und wobei
die kovalente Einbindung des Metallkomplexes an das Polymer durch Reaktion der Ankergruppe des Metallkomplexes mit einem dritten Reaktanden erfolgt, der zwei Ankergruppen einer zweiten Ankergruppenspezies aufweist.

5. Verfahren nach Anspruch 4, wobei das Reaktionsprodukt ein mehrdimensionales Netzwerk mit querverknüpften organischen Metallkomplexen darstellt, das unlöslich ist.

6. Verfahren nach Anspruch 1 bis 5, wobei die erste und zweite Ankergruppenspezies ausgewählt ist aus der in Figur 2 gezeigten Gruppe.

7. Verfahren nach Anspruch 1 bis 6, wobei ein vierter Reaktand zum Transport oder zur Blockierung elektrischer Ladungen an der Reaktion teilnimmt, der eine Ankergruppe der ersten oder zweiten Ankergruppenspezies aufweist.

8. Verfahren nach Anspruch 1 bis 7, wobei neben dem ersten Reaktanden, dem zweiten Reaktanden, optional dem dritten Reaktanden und optional dem vierten Reaktanden kein weiterer Reaktand an der Reaktion teilnimmt.

9. Polymer mit einem kovalent gebundenen organischen Metallkomplex, herstellbar durch ein Verfahren nach Anspruch 1 bis 8.

10. Verwendung eines Polymers nach Anspruch 9 als Emitter oder Absorber in einem optoelektronischen Bauelement.

11. Optoelektronisches Bauelement, aufweisend ein Polymer nach Anspruch 9, wobei das optoelektronische Bauelement ausgewählt ist aus der Gruppe bestehend aus organischen Leuchtidioden (OLEDs), lichtemittierenden elektrochemischen Zellen (LEECs oder LECs), OLED-Sensoren, insbesondere nicht hermetisch nach außen abgeschirmten Gas- und Dampf-Sensoren, optischen Temperatur-Sensoren, organischen Solarzellen (OSCs), organischen Feldeffekttransistoren, organischen Dioden, organischen Photodioden und "down conversion" Systemen.

12. Verfahren zur Herstellung einer Schicht eines an ein Polymer gebundenen organischen Metallkomplexes, aufweisend die Schritte des
- Auftragen eines Reaktionsproduktes aus einer ersten Reaktion aufweisend
- einem ersten Reaktanden in Form eines organischen Metallkomplexes und
- einem zweiten Reaktanden in Form eines Polymers, insbesondere zur Ausbildung eines mehrdimensionalen Netzwerkes
auf einen festen Träger, und
- Durchführen einer Reaktion zwischen dem ersten Reaktanden und dem zweiten Reaktanden
**dadurch gekennzeichnet, dass**
die Reaktion zwischen dem ersten Reaktanden und dem zweiten Reaktanden durch den Metallkomplex katalysiert wird.

13. Organischer Metallkomplex mit mindestens einem Metallzentrum und mindestens einem organischen Liganden,
**gekennzeichnet durch**
eine Ankergruppe einer ersten Ankergruppenspezies zur Reaktion mit einer Ankergruppe einer zweiten Ankergruppenspezies zur Querverknüpfung,
wobei jeweils eine der zwei Ankergruppe des Metallkomplexes während einer Querverknüpfungsreaktion zu einer Ankergruppe eines zweiten Reaktanden zur Ausbildung eines mehrdimensionalen Netzwerkes eine kovalente Bindung ausbilden kann.

14. Verwendung eines organischen Metallkomplexes nach Anspruch 13 zur Anbindung oder Querverknüpfung des Metallkomplexes mit einem zweiten Reaktanden zur Ausbildung eines mehrdimensionalen Netzwerkes.
